# EUROPEAN PATENT SPECIFICATION

(11) **EP 1 344 259 B1**
(45) Date of publication and mention of the grant of the patent: **13.02.2008**
(21) Application number: 01985912.3
(22) Date of filing: 19.12.2001
(51) Int. Cl.: H01L 31/108, H01L 31/0376, H01L 31/0368, H01L 27/16

(54) **OPTOELECTRONIC COMPONENT FOR CONVERSION OF ELECTROMAGNETIC RADIATION INTO AN INTENSITY-DEPENDENT PHOTOCURRENT**
OPTOELEKTRONISCHES BAUELEMENT ZUR UMWANDLUNG ELEKTROMAGNETISCHER STRAHLUNG IN EINEN INTENSITÄTSABHÄNGIGEN FOTOSTROM
COMPOSANT OPTOELECTRONIQUE POUR CONVERTIR UN RAYONNEMENT ELECTROMAGNETIQUE EN UN COURANT PHOTOELECTRIQUE DEPENDANT DE L'INTENSITE

(30) Priority: 21.12.2000 DE 10063837
(43) Date of publication of application: 17.09.2003
(73) Proprietor: STMicroelectronics N.V., 1118 BH Schiphol Airport Amsterdam (NL)
(72) Inventor: RIEVE, Peter, 51570 Windeck-Dattenfeld (DE); WAGNER, Michael, 01900 Bretnig-Hauswalde (DE); PRIMA, Jens, 49596 Gehrde (DE); WALDER, Marcus, 51688 Wipperfürth (DE)
(74) Representative: Adler, Peter
(86) International application number: PCT/EP2001/015083
(87) International publication number: WO 2002/050921

(56) References cited:
- EP-A- 1 026 747
- EP-A- 1 045 450
- EP-A- 1 102 321
- EP-A- 1 122 790
- US-A- 5 936 261
- PATENT ABSTRACTS OF JAPAN vol. 010, no. 082 (E-392), 2. April 1986 (1986-04-02) & JP 60 227467 A (NIPPON DENKI KK), 12. November 1985 (1985-11-12)

## Description

The invention relates to an optoelectronic component for converting electromagnetic radiation into an intensity-dependent photocurrent comprising a substrate formed in CMOS technology, in particular, with an integrated semiconductor structure (ASIC) and an optically active thin-film structure arranged upstream in the direction of light incidence and comprising in each case at least one layer made of doped and at least one layer made of undoped semiconductor material, which is connected to a microelectronic circuit arranged on the substrate by means of an insulating layer, within which are situated connecting means for contact-connecting the optically active thin-film structure to the semiconductor structure.

A method and a component of the type mentioned in the introduction are disclosed in US 5 936 261 "ELEVATED IMAGE SENSOR ARRAY WHICH INCLUDES ISOLATION BETWEEN THE IMAGE SENSORS AND A UNIQUE INTERCONNECTION" and MRS Symposium Proceedings, "Amorphous and Heterogeneous Silicon Thin Films 2000", vol. 69 "Hydrogeneated Amorphous Silicon Photodiode Technology for Advanced CMOS Active Pixel Sensors Imagers", J. A. Theil, M. Cao, G. Kooi, G.W. Ray, W. Greene, J. Lin, A. J. Budrys, U. Yoon, S. Ma and H. Stork.

A component of the type described serves for converting electromagnetic radiation into an intensity-dependent photocurrent in combination with an optoelectronic sensor in so-called thin-film on ASIC (TFA) technology. The electronic circuits arranged on the substrate and serving for the operation of the sensor are, on the one hand, the electronics for driving individual pixels, which are formed on the surface of the substrate either in a matrix-organized manner or in a linear arrangement as individual pixels that are functionally separate from one another and, on the other hand, peripheral electronics for driving the individual pixel electronics and also the superordinate system electronics. The electronics described are usually realized in silicon technology, based on CMOS technology, and conventionally formed by an application specific integrated circuit (ASIC). Situated on this structure, in a manner arranged upstream in the direction of light incidence, are firstly an insulating layer and, on the latter, a multilayer arrangement, i.e. a so-called optically active thin-film system which functions as a photodiode. The connection between the optically active thin-film structure and the electronics realized in the integrated circuit is effected by means of corresponding electrical contacts, so-called vias or tungsten plugs (W plugs). Individual spatially adjacent pixels are in each case arranged in the horizontal plane of the optoelectronic component. Photodiodes assigned to the individual pixels are formed in the optically active thin-film structure, and perform the conversion of electromagnetic radiation into an intensity-dependent photocurrent. The photocurrent is detected pixel by pixel in accordance with the electromagnetic radiation impinging on the individual pixels and is transferred by means of corresponding contacts, present in each pixel, to the underlying pixel electronics in the ASIC, the control of the exposure and integration operation being undertaken by the peripheral electronics.

In the configuration known from the prior art, the photodiode is formed by a structure which is identical to that of a pin diode, i.e. by a sequence comprising a p-conducting layer, an intrinsically conducting layer and an n-conducting layer. These are amorphous silicon layers in each case. An additional metal layer is formed on that side of the thin-film structure which faces the ASIC, while a transparent conductive layer is present on the side facing the direction of light incidence.

The known optoelectronic component has the disadvantage that it generates a comparatively high dark current. In this case, the therm "dark current" denotes that current of the photodiode which flows and generates a so called "dark signal" even when the illumination is switched off. Physically, the dark current is instigated by thermal generation of charge carriers in the photodiode. Further causes of the generation of a dark current may also be inhomogeneities on the surface of the ASIC structure, for example those brought about by metal tracks or holes in a passivation layer. By way of example, at surface edges, during the deposition of the amorphous silicon layers, in particular with the aid of the customary PECVD method (Plasma Enhanced Chemical Vapor Deposition), variations in the layer thicknesses arise which locally result in a higher dark current density and may determine the overall magnitude of the dark current. These additional dark currents - attributed to the surface topography of an ASIC - of the photodiodes situated thereon may exceed the thermal generation currents by many orders of magnitude and thus generate a significant dark signal. Consequently, the image quality of the sensor is greatly reduced at low illumination densities, resulting in a lower sensibility

A further disadvantage of the arrangement described is that the method for fabricating the component is comparatively complicated owing to the multiplicity of photolithographiy processes. In particular, the photolithographiy photolithographic patterning step for the pixel-by-pixel separation of the doped silicon layers situated on the photodiode rear contacts is critical because the vacuum process for carrying out the photolithography step has to be interrupted, which adversely affects the dark current of the photodiodes and the yield.

An example for an individual pixel structure with the described disadvantages is described in the EP 1 026 747 A2 with an active pixel sensor having an amorphous silicon sensing layer and a semiconductor readout layer.

The EP 1 102 321 A2 offers another example with an individual pixel structure with PIN or NIP diodes. Each of the pixel electrodes or groups of pixel electrodes are provided with guard rings. The pixel electrodes and the guard rings are made of a doped silicon, e.g an N-layer of amorphous silicon.

Therefore, the invention is based on the object of providing an optoelectronic component as recited in claim 1, and a method for fabricating it as recited in claim 11, which, on the one hand, can be fabricated more simply and, on the other hand, has a reduced dark current.

In the case of a component of the type mentioned in the introduction, this object is achieved according to the invention by virtue of the fact that the optically active thin-film structure has a layer sequence made of a metal and an intrinsically conducting amorphous or microcrystalline semiconductor, in particular silicon and alloys thereof, which is applied directly to the insulating layer. In the case of a method of the type mentioned in the introduction, this object is achieved by virtue of the fact that an optically active thin-film structure which has a layer sequence made of a metal and an intrinsically conducting amorphous or microcrystalline semiconductor material, in particular silicon or alloys thereof, is applied directly to the planarized insulating layer.

The invention is distinguished by the fact that a metal-semiconductor junction in the manner of a Schottky diode is used instead of the pin diode known from the prior art within the optically active thin-film structure. In the fabrication of the component, an additional photolithographic patterning step is avoided by virtue of the simplification of the structure. Furthermore, the structure described has the advantage that it is situated on a planarized ASIC surface, i.e. on a surface topography that is planar in comparison with the thickness of the photodiode, so that a significantly lower dark current is produced as a result of this.

Further preferred embodiments of the invention emerge from the subclaims.

The invention is explained in more detail below with reference to a drawing, in which:
- Figure 1: shows the structure of an optoelectronic component according to the prior art;
- Figure 2: shows the structure of an optoelectronic component in cross section in accordance with an exemplary embodiment of the present invention.

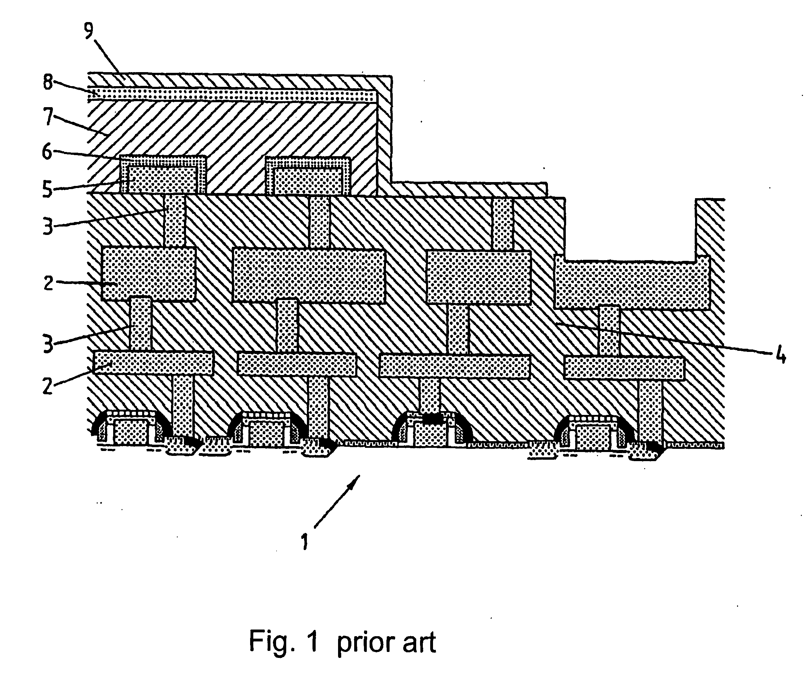

The optoelectronic component in accordance with the prior art as illustrated in Figure 1 comprises a substrate 1, i.e. a silicon substrate, on whose surface corresponding integrated circuits are formed. The technology used in this case is realized in CMOS technology, and the circuit thus formed is referred to as an application specific integrated circuit ASIC. An insulating layer 4 applied on the surface of the ASIC, accommodated within which insulating layer are metallizations 2 which extend essentially horizontally and which are electrically connected to one another by means of vias 3, serves for contact-connecting the ASIC to an optical thin-film structure, comprising the layers 5, 6, 7, 8, 9, that is yet to be described. Consequently, a direct electrical contact is produced between the desired positions on the surface of the integrated circuit and a metal layer 5 representing the bottommost layer of the optical structure, facing the ASIC.

Each of the metal layer contacts 5, which serves as base connection for the individual pixel contacts, is covered with an amorphous silicon layer 6, which overlaps the metal layer 5 and is formed as an n-type a-Si:H layer. Situated above that is an intrinsically conducting amorphous silicon layer 7, on which, in turn, a p-type-doped amorphous silicon layer 8 is situated. The entire structure thus formed is covered with a layer made of a conductive transparent oxide 9, which represents that layer of the overall structure which is arranged upstream in the direction of light incidence.

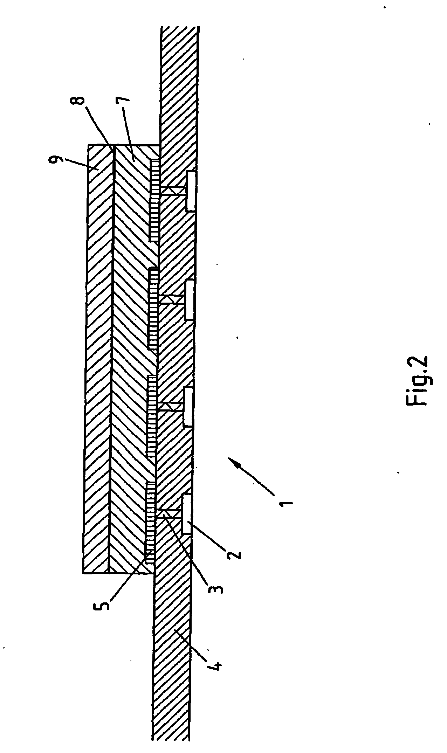

By contrast, Figure 2 shows the construction of an optoelectronic component in accordance with an exemplary embodiment of the present invention:

An insulating layer 4, a so-called intermetallic dielectric layer, is applied to the substrate 1 with the ASIC, which is formed in a manner corresponding to that in the prior art, which layer has been planarized by means of chemical mechanical polishing, so that the metallic contact connections, that is to say the horizontal connecting means 2 and the vias 3, are embedded in the intermetallic dielectric layer in such a way that no appreciable surface roughnesses arise. The connections between the individual metal layers 2 is effected by connecting vias 3 made of tungsten. The latter are also referred to as W plugs. According to a preferred exemplary embodiment of the invention, a titanium nitride barrier layer is additionally introduced between the insulating layer 4 and the metal layer 5, described below. Situated above said barrier layer is a metal layer 5 made of chromium, which has a thickness of 100 nm or less and is applied for example by the method of sputtering. This metal layer is patterned in such a manner as to produce back electrodes for the individual pixels. Situated above the metal layer 5 is an intrinsically conducting layer 7 of amorphous or microcrystalline silicon or alloys thereof, which has a thickness of typically approximately 0.5 µm to 2 µm and is preferably applied by the PECVD method. Finally, situated above the intrinsically conducting layer 7 is a p-conducting layer made of amorphous or microcrystalline silicon 8 or alloys thereof, which has a thickness of typically approximately 5 nm to 20 nm. A front contact in the form of a conductive transparent oxide layer is situated on the p-conducting layer 8. The material used for this is preferably aluminum-doped zinc oxide, aluminum-oxide-doped zinc oxide or, alternatively, indium tin oxide.

The layer sequence metal - chromium/intrinsically conducting amorphous silicon produces the structure of a Schottky diode in the form of a metal-semiconductor junction on a planarized ASIC surface.

This results in an extreme reduction of the dark current in comparison with the prior art.

Furthermore, the fabrication of the component according to the invention is also very much simpler since a photolithographic step for fabricating an additional n-doped silicon layer is obviated.

## Claims

1. An optoelectronic component for converting electromagnetic radiation into an intensity-dependent photocurrent comprising a substrate (1) formed in CMOS technology, with an integrated semiconductor structure (ASIC) and an optically active thin-film structure (7, 8, 9) arranged upstream in the direction of light incidence and comprising at least one layer made of undoped (7) semiconductor material, which is connected to a microelectronic circuit arranged on the substrate (1) by means of an insulating layer (4), within which are situated connecting means (2, 3) for contact-connecting the optically active thin-film structure (7, 8, 9) to the semiconductor structure, **characterized in that** the optically active thin-film structure, which is applied to the insulating layer (4), has a layer sequence made of a titanium nitride barrier layer followed by a plurality of metal (5) electrodes and an intrinsically conducting layer (7) that contacts the plurality of metal (5) electrodes forming Schottky diodes, the intrinsically conducting layer (7) being made of amorphous or microcrystalline semiconductor material, such as silicon or alloys thereof, and further comprising an extrinsically conducting layer (8) that contacts the intrinsically conducting layer (7) and a conductive transparent layer (9) disposed on the layer sequence.

2. The optoelectronic component as claimed in claim 1, **characterized in that** an extrinsically conducting layer (8) made of amorphous or microcrystalline silicon or alloys thereof is applied to the intrinsically conducting layer (7).

3. The optoelectronic component as claimed in claim 1 or 2, **characterized in that** the extrinsically conducting layer (8) is a p-doped layer.

4. The optoelectronic component as claimed in one of the preceeding claims, **characterized in that** a layer of a transparent conductive oxide (9), such as aluminium-doped zinc oxide, aluminium-oxide-doped zinc oxide or indium tin oxide, that is applied to the extrinsically conducting layer (8).

5. The optoelectronic component as claimed in one of the preceeding claims, **characterized in that** further optical filter layers are applied to the layer (9) of the transparent conductive oxide.

6. The optoelectronic component as claimed in one of the preceeding claims, **characterized in that** the metal of the layer sequence is chromium or a chromium-containing alloy, which is applied by sputtering.

7. The opoelectronic component as claimed in one of the preceeding claims, **characterized in that** the metal of the layer sequence is palladium, silver or titanium.

8. The optoelectronic component as claimed in one of the preceeding claims, **characterized in that** the connecting means comprise vias (3), which are composed of tungsten.

9. The optoelectronic component as claimed in one of the preceeding claims, **characterized in that** the insulating layer (4) is formed by a planarized intermetallic dielectric in which the connecting means including the vias (3) are embedded.

10. The optoelectronic component as claimed in one of the preceeding claims, **characterized in that** a further barrier layer, in particular titanium nitride, is situated between the insulating layer (4) and the metal layer(5).

11. A method for fabricating an optoelectronic component for converting electromagnetic radiation into an intensity-dependent photocurrent comprising a substrate (1) formed in CMOS technology, with an integrated semiconductor structure (ASIC) and an optically active thin-film structure (7, 8, 9) arranged upstream in the direction of light incidence and comprising at least one layer made of doped (8) and at least one layer made of undoped (7) semiconductor material, which is connected to a microelectronic circuit arranged on the substrate (1) by means of an insulating layer (4), within which are situated connecting means (2, 3) for contact-connecting the optically active thin-film structure (7, 8, 9) to the semiconductor structure, **characterized in that** an optically active thin-film structure is applied to the planarized insulating layer (4), wherein the thin-film structure has a layer sequence made of a plurality of metal (5) electrodes and an intrinsically conducting layer (7) that contacts the plurality of metal (5) electrodes, made of amorphous or microcrystalline semiconductor material, such as silicon or alloys (7) thereof, and a conductive transparent layer (9) disposed on the layer sequence.

12. The method for fabricating an optoelectronic component as claimed in claim 11, **characterized in that** the metal/intrinsic semiconductor layer sequence is applied on a planarized integrated semiconductor structure.

13. The method for fabricating an optoelectronic component as claimed in claim 12, **characterized in that** the integrated semiconductor structure is planarized by means of chemical mechanical polishing.

14. The method for fabricating an optoelectronic component as claimed in one of claims 11 to 13, **characterized in that** the topmost metal layer of the integrated semiconductor structure is completely or partially removed.

## Patentansprüche

1. Optoelektronische Komponente zur Umwandlung elektromagnetischer Strahlung in einen intensitätsabhängigen Photostrom, umfassend ein in CMOS-Technologie hergestelltes Substrat (1), mit einer integrierten Halbleiterstruktur (ASIC) und einer optisch aktiven Dünnfilmstruktur (7, 8, 9), die stromauf in Richtung des Lichteinfalls angeordnet ist und wenigstens eine Schicht aus einem undotierten (7) Halbleitermaterial umfasst, welches mit einer mikroelektronischen Schaltung, die auf dem Substrat angeordnet ist, mittels einer Isolierschicht (4) verbunden ist, in der Verbindungsmittel (2, 3) zur Kontakt-Verbindung mit der optisch aktiven Dünnfilmstruktur (7, 8, 9) angeordnet sind, **dadurch gekennzeichnet, dass** die optisch aktive Dünnfilmstruktur, die auf der Isolierschicht (4) aufgetragen ist, eine Schichtfolge aufweist, bestehend aus einer Titannitridschicht, gefolgt von einer Vielzahl von Metallelektroden (5) und einer eigenleitenden Verbindungsschicht (7), welche die Vielzahl von Metallelektroden (5) unter Bildung von Schottky-Dioden kontaktiert, wobei die eigenleitende Schicht (7) aus amorphem oder mikrokristallinem Halbleitermaterial wie Silizium oder dessen Legierungen gefertigt ist und weiterhin eine fremdleitende Schicht (8) umfasst, welche die eigenleitende Schicht (7) Kontaktiert und eine leitende transparente Schicht (9), die auf der Schichtfolge angeordnet ist.

2. Optoelektronische Komponente nach Anspruch 1, **dadurch gekennzeichnet, dass** eine fremdleitende Schicht (8), gefertigt aus amorphem oder monokristallinem Silizium oder Legierungen davon, auf der eigenleitenden Schicht (7) angeordnet ist.

3. Optoelektronische Komponente nach Anspruch 1 oder 2, **dadurch gekennzeichnet, dass** die fremdleitende Schicht (8) eine p-dotierte Schicht ist.

4. Optoelektronische Komponente nach einem der vorhergehenden Ansprüche, **dadurch gekennzeichnet, dass** eine Schicht aus einem transparenten leitfähigen Oxyd (9), wie mit Aluminium dotiertes Zinkoxid, mit Aluminiumoxid dotiertes Zinkoxyd oder Indium Zinn Oxyd auf der fremdleitenden Schicht (8) angeordnet ist.

5. Optoelektronische Komponente nach einem der vorhergehenden Ansprüche, **dadurch gekennzeichnet, dass** weiterhin optische Filterschichten auf der Schicht (9) des transparenten leitfähigen Oxydes aufgebracht sind.

6. Optoelektronische Komponente nach einem der vorhergehenden Ansprüche, **dadurch gekennzeichnet, dass** das Metall der Schichtfolge Chrom oder eine Chrom enthaltende Legierung ist, die durch Sputtern aufgebracht ist.

7. Optoelektronische Komponente nach einem der vorhergehenden Ansprüche, **dadurch gekennzeichnet, dass** das Metall der Schichtfolge Palladium, Silber oder Titan ist.

8. Optoelektronische Komponente nach einem der vorhergehenden Ansprüche, **dadurch gekennzeichnet, dass** die Verbindungsmitte Vias (3) umfassen, die aus Wolfram bestehen.

9. Optoelektronische Komponente nach einem der vorhergehenden Ansprüche, **dadurch gekennzeichnet, dass** die Isolierschicht (4) aus einem planarisierten zwischenmetallischen Dielektrikum gefertigt ist, in welches die Verbindungsmittel einschließlich der Vias (3) eingebettet sind.

10. Optoelektronische Komponente nach einem der vorhergehenden Ansprüche, **dadurch gekennzeichnet, dass** eine weitere Barriereschicht, insbesondere Titannitrid, zwischen der Isolierschicht (4) und der Metallschicht (5) angeordnet ist.

11. Verfahren zur Herstellung einer optoelektronischen Komponente zum Umwandeln elektromagnetischer Strahlung in einen intensitätsabhängigen Photostrom, umfassend ein in CMOS-Technologie gefertigtes Substrat (1), mit einer intergrierten Halbleiterstruktur (ASIC) und einer optisch aktiven Dünnfilmstruktur (7, 8, 9), die stromauf in Richtung des Lichteinfalls angeordnet sind und wenigstens eine Schicht aus einem dotierten (8) und wenigstens eine Schicht aus einem undotierten (7) Halbleitermaterial umfasst, die mit einer mikroelektronischen Schaltung auf dem Substrat (1) verbunden sind, wobei zwischen diesen Verbindungsmittel (2, 3) zur Kontaktverbindung der optischen aktiven Dünnfilmstruktur (7, 8) mit der Halbleiterstruktur positioniert sind, **dadurch gekennzeichnet, dass** eine optisch aktive Dünnfilmstruktur auf einer planarisierten Isolierschicht (4) aufgetragen ist, wobei die Dünnfilmstruktur eine Schichtfolge aufweist, die aus einer Vielzahl von Metallelektroden (5) und einer eigenleitenden Schicht (7) besteht, welche die Vielzahl der Metall (5) Elektroden kontaktiert und aus amorphem oder monokristallinem Halbleitermaterial, wie Silizium oder dessen Legierungen (7), besteht und einer leitfähigen transparenten Schicht (9), die auf der Schichtfolge angeordnet ist.

12. Verfahren zur Herstellung einer optoelektronischen Komponente nach Anspruch 12, **dadurch gekennzeichnet, dass** Metall/eigenleitende Halbleiterschichtfolge auf eine planarisierten integrierte Halbleiterstruktur aufgetragen ist.

13. Verfahren zur Herstellung einer optoelektronischen Komponente nach Anspruch 12, **dadurch gekennzeichnet, dass** die Struktur mit Hilfe des chemischen mechanischen Polierens planarisiert ist.

14. Verfahren zur Herstellung einer optoelektronischen Komponente nach einem der Ansprüche 11 bis 13, **dadurch gekennzeichnet, dass** die oberste Metallschicht der integrierten Halbleiterstruktur vollständig oder teilweise entfernt ist.

## Revendications

1. Composant optoélectronique pour convertir un rayonnement électromagnétique en un courant photoélectrique dépendant de l'intensité, comportant un substrat (1) réalisé en technologie CMOS, avec une structure à semi-conducteurs intégrés (ASIC) et une structure à couches minces optiquement active (7, 8, 9) installées en amont dans la direction de l'incidence de la lumière et comportant au moins une couche constituée d'un matériau à semi-conducteurs non dopé (7), et connectée à un circuit micro-électronique sur le substrat (1) par l'intermédiaire d'une couche isolante (4) logeant un moyen de connexion (2, 3) pour relier par contact la structure à couches minces optiquement active (7, 8, 9) à la structure à semi-conducteurs,
**caractérisé en ce que**
la structure à couches minces optiquement active appliquée sur la couche isolante (4), comporte une séquence de couches constituée d'une couche de barrière de nitrure de titane suivie d'une pluralité d'électrodes métalliques (5) et d'une couche intrinsèquement conductrice (7) qui est au contact de la pluralité d'électrodes métalliques (5) pour former des diodes Schottky, la couche intrinsèquement conductrice (7) étant constituée d'un matériau à semi-conducteurs amorphes ou micro-cristallins, tels que du silicium ou ses alliages, et comportant en outre une couche extrinsèquement conductrice (8) qui se trouve en contact avec la couche intrinsèquement conductrice (7), et une couche transparente conductrice (9) disposée sur la séquence de couches.

2. Composant optoélectronique selon la revendication 1,
**caractérisé en ce qu'**
une couche extrinsèquement conductrice (8) constituée de silicium amorphe ou micro-cristallin, ou des ses alliages, est appliquée à la couche intrinsèquement conductrice (7).

3. Composant optoélectronique selon la revendication 1 ou 2,
**caractérisé en ce que**
la couche extrinsèquement conductrice (8) est une couche à dopage P.

4. Composant optoélectronique selon l'une quelconque des revendications précédentes,
**caractérisé en ce qu'**
une couche d'un oxyde conducteur transparent (9), tels que de l'oxyde de zinc dopé à l'aluminium, de l'oxyde de zinc dopé à l'oxyde d'aluminium ou de l'oxyde indium-étain, est appliquée à la couche extrinsèquement conductrice (8).

5. Composant optoélectronique selon l'une quelconque des revendications précédentes,
**caractérisé en ce que**
des couches de filtre optique supplémentaires sont appliquées à la couche (9) d'oxyde conducteur transparent.

6. Composant optoélectronique selon l'une quelconque des revendications précédentes,
**caractérisé en ce que**
le métal de la séquence de couches est constitué de chrome ou d'un alliage contenant du chrome, qui est appliqué par pulvérisation cathodique.

7. Composant optoélectronique selon l'une quelconque des revendications précédentes,
**caractérisé en ce que**
le métal de la séquence de couches est constitué de palladium, d'argent ou de titane.

8. Composant optoélectronique selon l'une quelconque des revendications précédentes,
**caractérisé en ce que**
le moyen de connexion comprend des trous d'interconnexion (3), qui sont constitués de tungstène.

9. Composant optoélectronique selon l'une quelconque des revendications précédentes,
**caractérisé en ce que**
la couche d'isolation (4) est réalisée au moyen d'un diélectrique intermétallique planarisé dans lequel est imbriqué le moyen de connexion incluant les trous d'interconnexion (3).

10. Composant optoélectronique selon l'une quelconque des revendications précédentes,
**caractérisé en ce qu'**
une couche de barrière supplémentaire, constituée en particulier de nitrure de titane, se situe entre la couche d'isolation (4) et la couche métallique (5).

11. Procédé de fabrication d'un composant optoélectronique pour convertir un rayonnement électromagnétique en un courant photoélectrique dépendant de l'intensité, comportant un substrat (1) réalisé en technologie CMOS, une structure à semi-conducteurs intégrés (ASIC) et une structure à couches minces optiquement active (7, 8, 9) installées en amont dans la direction de l'incidence de la lumière et comportant au moins une couche constituée d'un matériau à semi-conducteurs dopé (8) et au moins une couche constituée d'un matériau à semi-conducteurs non dopé (7), qui est connectée à un circuit micro-électronique sur le substrat (1) au moyen d'une couche isolante (4) logeant un moyen de connexion (2, 3) pour relier par contact la structure à couches minces optiquement active (7, 8, 9) à la structure à semi-conducteurs,
**caractérisé en ce qu'**
une structure à couches minces optiquement active est appliquée sur la couche isolante planarisée (4), la structure à couches minces comporte une séquence de couches constituées d'une pluralité d'électrodes métalliques (5), et d'une couche intrinsèquement conductrice (7) qui entre en contact avec la pluralité d'électrodes métalliques (5), formées d'un matériau à semi-conducteurs amorphes ou micro-cristallins, tel que du silicium ou ses alliages (7), et une couche transparente conductrice (9) disposée sur la séquence de couches.

12. Procédé de fabrication d'un composant optoélectronique selon la revendication 11,
**caractérisé en ce que**
la séquence de couches à semi-conducteurs métalliques/intrinsèques est appliquée sur une structure à semi-conducteurs intégrés et planarisés.

13. Procédé de fabrication d'un composant optoélectronique selon la revendication 12,
**caractérisé en ce que**
la structure à semi-conducteurs intégrés est planarisée par un polissage mécanique et chimique.

14. Procédé de fabrication d'un composant optoélectronique selon l'une quelconque des revendications 11 à 13,
**caractérisé en ce que**
la couche métallique supérieure de la structure à semi-conducteurs intégrés est intégralement ou partiellement éliminée.
